# EUROPEAN PATENT APPLICATION

(11) **EP 1 808 405 A2**
(43) Date of publication of application: **18.07.2007**
(21) Application number: 07100500.3
(22) Date of filing: 12.01.2007
(51) Int. Cl.: B81C 1/00

(54) **Integrated package for MEMS die and IC chip**

(30) Priority: 13.01.2006 US 306888
(71) Applicant: Honeywell International Inc., Morristown, NJ 07962 (US)
(72) Inventor: Macgugan, Douglas C., Bellevue, WA 98006 (US)
(74) Representative: Haley, Stephen

(57) **Abstract**

Systems and method of fabricating an integrated Micro-Electro-Mechanical Systems (MEMS) package 10. The MEMS package 10 includes a substrate 12 that has a substantially planar first surface including a cavity 27 configured to receive a MEMS die 24. A substantially planar second surface is parallel to and spaced apart from the first surface. The second surface is configured to receive a flip chip 33. The MEMS die 24 is inserted into the cavity 27. The flip chip 33 is affixed to the substrate 12 to establish operative connection between the MEMS die 24 and the flip chip 33 trough traces in the substrate 12.

## Description

The term Micro-Electro-Mechanical Systems (MEMS) describes an integration of mechanical elements, sensors, actuators, and electronics on a common silicon substrate through microfabrication technology. While the electronic circuits are fabricated using integrated circuit (IC) process sequences (e.g., CMOS, Bipolar, or BICMOS processes), the micromechanical components are fabricated using compatible "micromachining" processes that selectively etch away parts of the silicon wafer or add new structural layers to form the mechanical and electromechanical devices.

The physical mechanisms underlying MEMS accelerometers include capacitive, piezoresistive, electromagnetic, piezoelectric, ferroelectric, optical, and tunneling. The most successful types are based on capacitive transduction; the reasons are the simplicity of the sensor element itself, no requirement for exotic materials, low power consumption, and good stability over temperature. Although many capacitive transducers have a nonlinear capacitance as opposed to a displacement characteristic, feedback is commonly used to convert the signal to a linear output. Feedback loops exploit common analog electronic circuits known as operational amplifiers or op-amps.

All MEMS gyroscopes take advantage of the Coriolis effect. Many types of MEMS gyroscopes have appeared in the literature, with most falling into the categories of tuning-fork gyros, oscillating wheels, Foucault pendulums, and wine glass resonators. Tuning fork gyros, for example, contain a pair of masses that are driven to oscillate with equal amplitude but in opposite directions. When rotated, the Coriolis force creates an orthogonal vibration that can be sensed by a variety of mechanisms. Rotation causes the proof masses to vibrate out of plane, and this motion is sensed capacitively with supporting electronic circuitry.

MEMS sensors such as accelerometers require support electronics to drive the sensor or to create a signal interface allowing communication with a circuit. The size of the necessary electronic support circuits, however, generally tends to overshadow any size or power advantage gained through MEMS miniaturization of accelerometer or gyroscope mechanisms. Traces connecting the MEMS sensor to the electronic support circuitry are long due to remote placement of the electronic support circuitry. The length of the traces adds parasitic capacitance that degrades the output signal of the MEMS sensor. Additionally, having distinct sensors and electronics makes manufacture of the application exploiting the MEMS sensor expensive requiring distinct assembly processes together having a greater rate of rejection due to the likelihood of mismatching circuitry. What is needed in the art is an integrated electronics package design that is fully contained in a compact robust package.

A method of fabricating an integrated MEMS package includes providing a substrate. The substrate has a substantially planar first surface including a cavity configured to receive a MEMS die. A substantially planar second surface is parallel to and spaced apart from the first surface. The second surface is configured to receive a flip chip. The MEMS die is inserted into the cavity. The flip chip is affixed to the substrate to establish operative connection between the MEMS die and the flip chip through traces in the substrate.

An optional embodiment comprises a method including defining at least one first relief shelf in the inventive substrate, the first relief shelf configured to receive at least one of a capacitor, inductor, or resistor. The optional embodiment may also include defining at least one second relief shelf, the second relief shelf configured to receive at least one integrated circuit, such as an operational amplifier.

In accordance with further aspects of the invention, the method includes forming at least one contact in electrically conductive connection with at least one of the plurality of traces, the contact being configured to form a further electrically conductive connection between the at least one of the plurality of traces and a conductor in electrical connection with the contact. Embodiments include contacts that include solder balls or wire bonds. A plurality of contacts and wherein the plurality of contacts may, optionally, be configured to form a grid array matrix. The contacts may, advantageously, be situated on the first surface.

In accordance with other aspects of the invention, machining a cavity floor, the cavity floor being substantially parallel to the first surface serves to define the cavity. Optionally the floor of the cavity is metalized to form a conductive floor plane. The floor plane suitably serves as an attachment point for fixing the MEMS die or other MEMS devices.

In accordance with still further aspects of the invention, the cavity may be hermetically sealed to define a isobaric chamber to contain the MEMS die. The sealing may optionally be by means of a brazed lid.

As will be readily appreciated from the foregoing summary, the invention provides an integrated electronics package design that is fully contained in a compact robust package.

In the Drawings:

The preferred and alternative embodiments of the present invention are described in detail below with reference to the following drawings.
FIGURE 1 is a phantom perspective view of an Integrated MEMS package;
FIGURE 2 is a reverse phantom perspective view of the Integrated MEMS package;
FIGURE 3 is a isometric view of a composite circuit board containing six Integrated MEMS Packages; and,
FIGURE 4 is a flowchart of a method for constructing the Integrated MEMS package.

A method of fabricating an integrated MEMS package includes providing a substrate. The substrate has a substantially planar first surface including a cavity configured to receive a MEMS die. A substantially planar second surface is parallel to and spaced apart from the first surface. The second surface is configured to receive a flip chip. The MEMS die is inserted into the cavity. The flip chip is affixed to the substrate to establish operative connects between the MEMS die and the flip chip through traces in the substrate.

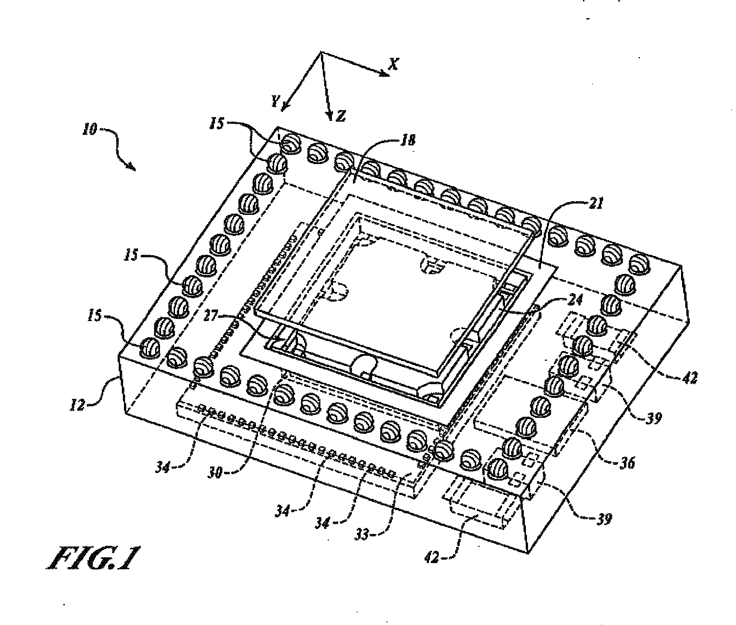

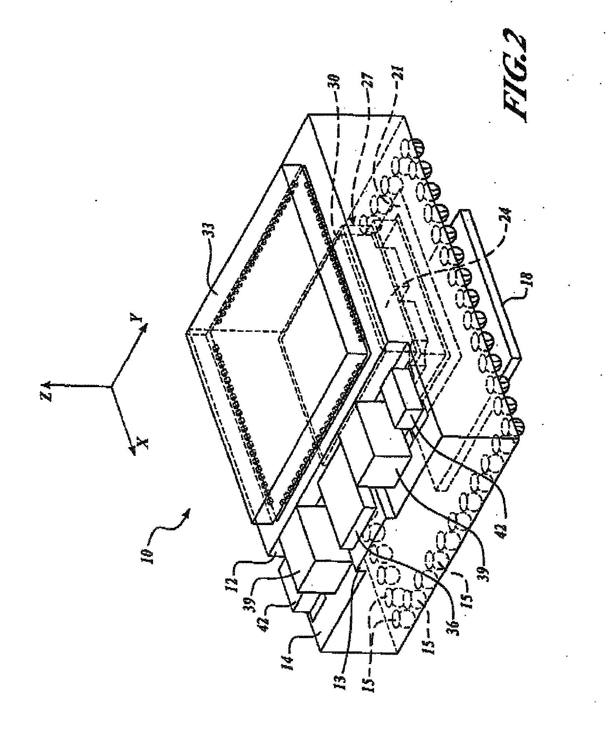

Referring to FIGS. 1 and 2, an integrated MEMS package 10 includes a substrate 12 having a first relieved shelf 13 and a second relieved shelf 14. On the first relieved shelf 13, in a preferred embodiment an integrated circuit 36 such as an operative amplifier is advantageously placed. Passive electrical components such as capacitors 39 or resistors 42 are used to trim or to drive the integrated circuit 36 are situated on a second relieved shelf.

A first surface of the substrate 12 supports an array matrix of solder ball contacts 15 and defines a cavity 27 configured to enclose a MEMS die or device 24. A metalized collar 21 is deposited on the first surface to surround the cavity 27 to allow brazing a lid 18 to hermetically seal the cavity 27 at desired pressure; the cavity 27 is sealed at vacuum, in another the cavity 27 is sealed at the ambient pressure. In all instances, sealing preserves an isobaric environment around MEMS die 24 to minimize variation in performance of the mechanism the MEMS die 24 contains as ambient pressure changes. A floor of the cavity 27 may be, optionally, metalized to form a ground plane 30. On a second surface, in the illustrated embodiment spaced apart from but parallel to the first surface, a flip chip 33 is placed. The placement of the flip chip 33 in opposed relation to the cavity 27 housing the MEMS dies facilitates routing of shortened traces within the substrate 12. These shortened traces significantly improve signal quality by reducing parasitic capacitance and inductance, especially when signals are sent over the shortened traces at higher frequencies.

In one embodiment, the substrate 12 is a generally rectangular prism. The substrate 12 includes traces (not shown) configured to form circuit that connect electrical and electronic components that the MEMS package 10 contains. Within the subsets 12, the traces, optionally, may define multilayer circuits to connect components such as an integrated circuit 36, the passive components, such as a capacitors 39 and a resistors 42 to be mounted on a substrate 12 in operative connection to the MEMS die 24. Preferred embedments include a substrate 12 fabricated in thick film, thin film; low-temperature cofired ceramic (LTCC), high-tempenture cofired ceramic (HTCC), and pure copper metallizations on ceramic.

The cavity 27 defined within the substrate 12 is configured to receive the MEMS die in operational connection. The traces (not shown) within the substrate 12 terminate at walls or floor of the cavity 27 to facilitate the flow of electrons into and out of the MEMS die.

The cavity 27 also facilitates an additional advantage of the substrate 12 as taught In the course of manufacture, the substrate 12 and the traces (not shown) within the substrate may be tested before mounting the tested MEMS die 24 in the substate. While not assuring that the assembled integrated MEMS package 10 will be operational, the rejection rate for the assembled integrated MEMS package 10 is generally much lower when the substrate 12 and the MEMS die 24 are separately testable before assembly. Assembly from "known good" components is far less costly than finally testing an assembled component

The second surface receives the flip chip 33 thereby shortening designed length of traces from the MEMS die to the flip chip 33. The flip chip 33 is an integrated microelectronic assembly wherein direct electrical connection of face-down (hence, "flipped") electronic components onto substrates, circuit boards, or carriers, by means of conductive bumps 34 on the chip bond pads. As noted above, the flipping of the flip chip 33 allows mounting the flip chip 33 in opposed relationship to the cavity 27 on the substrate with shortened traces passing through the substrate 12 to the MEMS die.

Flip chip 33 components are predominantly semiconductor devices; however, components such as passive filters, detector arrays, and MEMS dies 24 are also beginning to be used in flip chip 33 form. The flip chip 33 is also called a direct chip attach (DCA), a more descriptive term, since the chip is directly attached to the substrate, board, or carrier by the conductive bumps 34.

In other embodiments, exploiting the flip chip 33 yields advantages in size, performance, flexibility, reliability, and cost over other packaging methods. Rather than developing traces to a surface mounted chip on the first surface, the use of the flip chip 33 offers the higher speed electrical performance. Eliminating trace length reduces the delaying inductance and capacitance of the connection, and shortens the path. The result is higher speed off-chip interconnection than is possible with side by side mounting on the substrate 12.

Additionally, the flip chip 33 gives the greatest input and output connection flexibility. Flip chip connections can use the whole area of the die, accommodating many more connections on a smaller die. Area connections also allow the opposed relationship between flip chip 33 and the mounted MEMS die 24.

The bumps 34 affix the flip chip 33 to the substrate 12. Electrically, the bumps 34 provide a conductive path from the flip chip 33 to the traces (not shown) within the substrate 12. The bumps 34 also provide a thermally conductive path to carry heat from the flip chip 33 to the substrate 12. In addition, the bumps 34 provide part of the mechanical mounting of the flip chip 33 to the substrate 12. Finally, the bumps 34 collectively provide a spacer between the flip chip 33 and the substrate 12, preventing electrical contact between the flip chip 33 and the traces in the substrate 12, and acting as a short lead to relieve mechanical strain between flip chip 33 and substrate 12.

To form the bumps 34, an under bump metallization (UBM) is placed on flip chip 33 bond pads, by sputtering, plating, or other means, to replace the insulating aluminum oxide layer and to define and limit the solder-wetted area. Solder is the deposited over the UBM by evaporation, electroplating, screenprinting solder paste, or needle-depositing.

Alternatively, plated bumps 34 on flip chip 33 fabrication uses wet chemical processes to remove the aluminum oxide and plate conductive metal bumps 34 onto the wafer bond pads. Plated nickel-gold bumps 34 are formed on the semiconductor wafer by electroless nickel-plating of the aluminum bond pads of the chips. After plating the desired thickness of nickel, an immersion gold layer is added for protection. Attachment generally is by solder or adhesive, which may be applied to the bumps 34 or the substrate bond pads by various techniques.

In a second alternative, a gold stud bump 34 is fabricated on the flip chip 33. A gold ball for wire bonding is formed by melting the end of a gold wire to form a sphere. The resulting gold ball is attached to the flip chip 33 bond pad as the first part of a wire bond. To form gold bumps 34 instead of wire bonds, wire bonders are modified to break off the wire after attaching the ball to the chip bond pad. The gold ball or "stud bump" 34 remaining on the bond pad provides a permanent connection through the aluminum oxide to the underlying metal.

The gold stud bump 34 process is unique in being readily applied to individual single die or to wafers. Gold stud bump flip chips 33 may be attached to the substrate bond pads with adhesive or by thermosonic gold-to-gold connection. A third alternative includes an adhesive bump 34. The flip chip 33 is stenciled with a conductive adhesive to form bumps 34 on an under-bump metal. The cured adhesive acts as bumps 34. Attachment is by an additional layer of conductive adhesive.

As described above, one function of the bump 34 is to provide a space between the flip chip 33 and the substrate 12. In a embodiment, an under-chip space the bumps 34 provide is then filled with a non-conductive "underfill" adhesive joining the entire surface of the chip to the substrate. The underfill protects the bumps 34 from moisture or other environmental hazards, and provides additional mechanical strength to the integrated MEMS package 10.

Such under fill includes compensation for any thermal expansion difference between the flip chip 33 and the substrate 12. Underfill adhesive mechanically "locks" the flip chip 33 and substrate 12.

In one embodiment, the whole of the MEMS package is fastenable to a board by means of an array of solder ball contacts 15. Known as a ball grid array, the may of solder ball contacts 15 is a popular packaging form for high speed 1/0 devices in industry. Its advantages over pin grid arrays or distinct solderable links, is that the solder ball contacts 15 expose no leads to bend and greatly reduced coplanarity problems as well as reducing handling issues. During reflow, the solder balls are self-centering (up to 50% off pad), thus reducing placement problems during surface mount. Normally, because of a large pitch (typically 1.27 mm) of a ball grid contact 15 array, the overall package and board assembly yields can be better than by using pin grid arrays. From a performance perspective, the thermal and electrical characteristics of arrays of solder balls are also better than arrays of pins.

Referring to FIG. 2, the second surface is configured to include the first relieved shelf 13 and the second relieved shelf 14. Each of the relieved shelves 13 and 14 are of a depth selected to further compact the integrated MEMS package 10 form factor given dimensions of the passive components such as the capacitors 39 and resistors 42 as well as the integrated circuit 36.

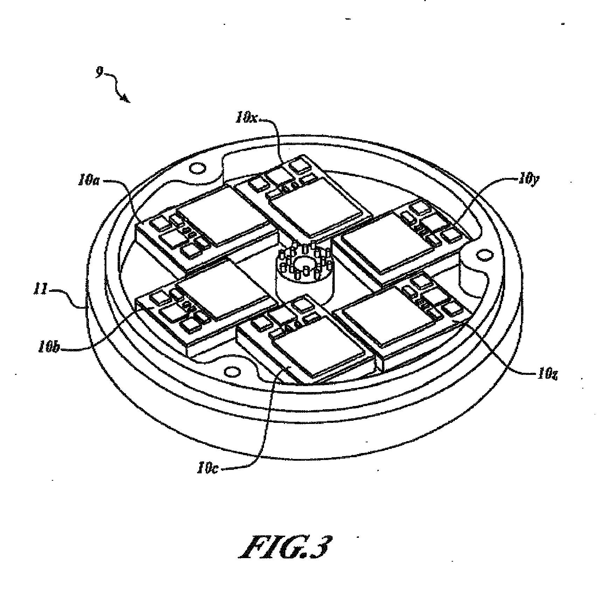

Referring to FIG. 3, a composite assembly 9, the integrated MEMS packages 10a, 10b, 10c, 10x, 10y, and 10z contains all of the functionality of either of a MEMS gyroscope or an inertial sensor including all drivers and signal conditioning circuitry within a greatly miniaturized form factor. The miniaturized form of the integrated MEMS package allows six of the integrated MEMS packages 10a, 10b, 10c, 10x, 10y, and 10z (a set of three MEMS gyroscopes 10x, 10y, and 10z in orthogonal relationship and a set of three MEMS inertial sensors in orthogonal relationship 10a, 10b, and 10c) to be configured on a single board 11. Such a board can be normalized for modular installation in any application requiring inertial or gyroscopic detection or to enhance reliability of GPS modules by providing inertial navigation where communication with a GPS satellite is occluded or jammed such as in military environments.

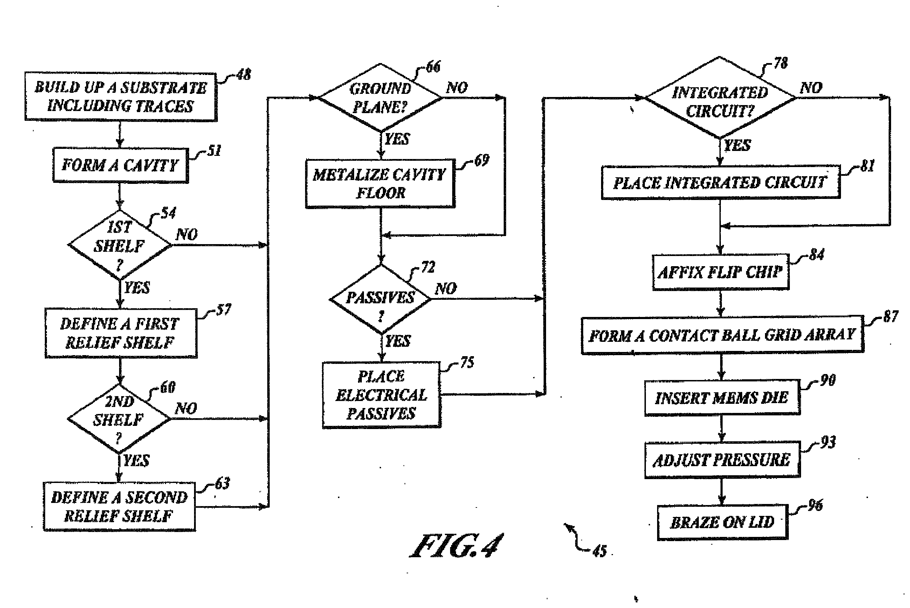

Referring to FIG. 4, a method 45 for assembly of an integrated MEMS package, includes, at a block 48, building up a substrate to include traces. In preferred embodiments include the substrate is fabricated in thick film; thin film; low-temperature cofired ceramic (LTCC); high-temperature cofired ceramic (HTCC); and pure copper metallizations on ceramic. The methods are selected to facilitate fabrication of multilayer trace paths configured to yield very short traces within the substrate.

A cavity is formed in the substrate at a block 51. The cavity is defined within the substrate and configured to receive the MEMS die in operational connection. Silicon bulk micromachining uses either etches that stop on the crystallographic planes of a silicon wafer or etches that act isotropically to generate mechanical parts. These techniques combined with wafer bonding and boron diffusion allow complex mechanical devices to be fabricated. Additionally, if the substrate is built in laminated layers, it may be optionally formed with the cavity in place and the laminates are built up. In a preferred embodiment the substrate has a generally planar first surface and a generally planar second surface spaced apart but parallel to the first surface.

At a block 54, a substrate design is examined for the desirability of a first shelf having a depth to offset the first shelf from the second surface. One reason for offsetting the first shelf from the second surface is to accommodate electrical components that have a height distinct from that of other components thereby optimizing the resulting form of the completed integrated MEMS package to fit within an idealized rectangular prism thereby easing design requirements in within a tightly packed space. In the event that a first relieved shelf is desirable, it is relieved into the second surface, in the preferred embodiment, to create the first shelf at a block 57.

Similarly, at a block 60, the desirability of a second relieved shelf is examined, and if determined desirable, at a block 63, a second shelf is relieved into the second surface.

At a block 66, the desirability of a metalized ground plane within the cavity is examined. While a ground plane may provide some shielding function, especially where the MEMS sensor relies upon capacitive changes to measure acceleration, the ground plane is also useful as an attachment point for bonding, soldering or other means of attaching a MEMS die or its component to a floor of the cavity.

To form a ground plane, the floor of the cavity is metalized at a block 69. As indicated before, the cavity might be metalized as a distinct step after the substrate is formed or fabricated with the traces as the substrate is built up in laminate layers.

Generally, passive elements are used in conjunction with operational amplifiers to drive elements within the MEMS die. Capacitors and resistors may be used to generate signal of a suitable frequency when used with an operational amplifier. Passive capacitors and resistors cannot be integrated into an integrated circuit and must be "hung on" the integrated MEMS package. Determining whether passive elements such as capacitors and resistors are to be incorporated into the integrated MEMS package occurs at a block 72.

If passive electrical components are used, the passive electrical components are bonded to contact pads the traces form on the first relieved shelf at a block 75. Resistors such as the Vishay 200 M Ohm resistors and capacitors such as the AVX 033µF 2 capacitor arrays are typical passive elements that may optionally be incorporated into the integrated MEMS package.

As indicated above, integrated circuit such as operational amplifiers are very frequently used as drivers for the MEMS die. Other integrated circuits are also very useful in driving the MEMS die. Deciding whether the design of the integrated MEMS package includes an integrated circuit occurs at a block 78.

At a block 81, one or more integrated circuits are mounted on the second relieved shelf. Integrated circuits include operational amplifiers such as the quad. OpAmp OP482 die manufactured by Analog. Mounting such integrated circuits occurs at a block 81.

A flip chip 84 is affixed to the substrate at a block 84. Generally, the flip chip is a signal conditioner such as a signal ASIC chip with peripheral bond pads Manufactured by AMI. The ASIC chip is designed with the application in mind in order to condition the signal output by the MEMS die in order to provide a useful and meaningful output.

At a block 87, a ball grid array is formed on the first surface of the integrated MEMS package. As opposed to a pin grid array, a ball grid array is a type of microchip connection methodology very similar to the bumps described above. Ball grid array chips typically use a group of solder dots, or balls, arranged in concentric rectangles to connect to a circuit board. Ball grid arrays are a presently preferred embodiment over another embodiment using a pin grid array, though both will serve. Ball grid arrays do not take up as much space as pin grid arrays due to the length of the pins used to connect the integrated MEMS package to a circuit board in an application.

At a block 90, the MEMS die is inserted in the cavity. MEMS dies used as accelerometers or as gyroscopes may be suitably manufactured to be oriented along each of an x, y, or a z axis thereby allowing integrated MEMS packages of distinct orientations to be manufactured on the same assembly line. The capability to manufacture integrated MEMS packages on the same assembly line further allows fabrication of boards having all three orientations on a single board without distinct integrated MEMS packages being fed to the board assembly machine.

At a block 93, the barometric pressure within the cavity is adjusted to meet the needs of the application. For instance, where a vacuum in the cavity is desire, ambient air is evacuated. While a vacuum is not necessary for operation of all MEMS devices, operation of a MEMS device in a vacuum is often more predictable than in the presence of air, in other operations, normalizing the pressure of the cavity to match the likely operating pressure might be more advantageous than operation in a vacuum as stresses imparted by the ambient pressure in the operating environment might distort the integrated MEMS package.

While the barometric pressure is held at a desirable level, the cavity is hermetically sealed at a block 96, when a lid is brazed onto the first surface to a metalized deposit on the first surface. Brazing reliably seals the cavity without unduly heating the substrate. Once the cavity is hermetically sealed, the assembly of the integrated MEMS device is complete.

While the preferred embodiment of the invention has been illustrated and described, as noted above, many changes can be made without departing from the spirit and scope of the invention. Accordingly, the scope of the invention is not limited by the disclosure of the preferred embodiment. Instead, the invention should be determined entirely by reference to the claims that follow.

## Claims

1. A substrate 12 as a component of an integrated MEMS package 10, the substrate comprising:
a substantially planar first surface, the first surface defining a cavity 27 configured to receive a MEMS die 24;
a substantially planar second surface parallel to and spaced apart from the first surface, the second surface configured to receive a flip chip 33; and
a plurality of conductive traces configured to conduct electrons, in the presence of the MEMS die 24 and flip chip 33, from the MEMS die 24 to the flip chip 33 in operative connection.

2. The substrate 12 of Claim 1, wherein the second surface defines at least one first relief shelf, the first relief shelf configured to receive at least one of a capacitor 39, inductor, or resistor 42.

3. The substrate 12 of Claim 1, further comprising:
at least one contact 15 in electrically conductive connection with at least one of the plurality of traces, the contact 15 being configured to form a further electrically conductive connection between the at least one of the plurality of traces and a circuit in electrical connection with the contact 15.

4. The substrate of Claim 3, wherein the contact includes a solder ball.

5. The substrate of Claim 3, wherein the contact includes a plurality of contacts 15 and wherein the plurality of contacts 15 are configured to form a grid array matrix.

6. The substrate of Claim 1, wherein the cavity 27 includes a cavity floor, the cavity floor 30 being substantially parallel to the first surface.

7. The substrate of Claim 9, wherein the cavity floor 30 is metalized.

8. The substrate of Claim 1, wherein the cavity 27 is hermetically sealed to define a chamber configured to contain the MEMS die 24.

9. A method of fabricating an integrated MEMS package, the method comprising:
providing a substrate 12 having:
a substantially planar first surface, the first surface defining a cavity 27 configured to receive a MEMS die 24;
a substantially planar second surface parallel to and spaced apart from the first surface, the second surface configured to receive a flip chip 33; and
a plurality of conductive traces;
inserting the MEMS die 24 into the cavity 27;
affixing the flip chip 33 to the substrate to establish operative connection between the MEMS die 24 and the flip chip 33 through the traces.

10. An integrated MEMS package comprising:
a substrate 12 having:
a substantially planar first surface, the first surface defining a cavity 27 configured to receive a MEMS die;
a substantially planar second surface parallel to and spaced spart from the first surface, the second surface configured to receive a flip chip 33; and
a plurality of conductive traces configured to conduct electrons, in the presence of the MEMS die 24 and flip chip 33, from the MEMS die 24 to the flip chip 33 in
operative connection;
a MEMS die 24 engaged in the cavity 27; and
a flip chip 33 engaged on the second surface in operative communication with the MEMS die 24.2. The substrate of Claim 1, wherein the second surface defines at least one first relief shelf, the first relief shelf configured to receive at least one of a capacitor, inductor, or resistor.
